(19) Europäisches Patentamt
European Patent Office
Office européen des brevets

(11) EP 1 863 180 B1

(12) **FASCICULE DE BREVET EUROPEEN**

(45) Date de publication et mention
de la délivrance du brevet:
**19.12.2012 Bulletin 2012/51**

(51) Int Cl.:
*H03M 1/06* *(2006.01)*     *H03M 1/12* *(2006.01)*

(21) Numéro de dépôt: **07354012.2**

(22) Date de dépôt: **05.03.2007**

(54) **Procédé et dispositif d'échantillonnage des signaux électriques d'une installation électrique multiphasée**

Verfahren und Vorrichtung zur Abtastung von elektrischen Signalen einer mehrphasigen elektrischen Anlage

Method and device for sampling electric signals of a multiphase electric installation

(84) Etats contractants désignés:
**AT BE BG CH CY CZ DE DK EE ES FI FR GB GR HU IE IS IT LI LT LU LV MC MT NL PL PT RO SE SI SK TR**

(30) Priorité: **02.06.2006 FR 0604944**

(43) Date de publication de la demande:
**05.12.2007 Bulletin 2007/49**

(73) Titulaire: **Schneider Electric Industries SAS**
**92500 Rueil-Malmaison (FR)**

(72) Inventeur: **Iurascu, Matei**
**38050 Grenoble Cedex 09 (FR)**

(74) Mandataire: **Tripodi, Paul et al**
**Schneider Electric Industries SAS**
**Service Propriété Industrielle**
**World Trade Center - E1**
**5 Place Robert Schuman**
**38050 Grenoble Cedex 9 (FR)**

(56) Documents cités:
**US-A- 4 388 611**

• **PETROVIC P ET AL: "Digital method for power frequency measurement using synchronous sampling" IEE PROCEEDINGS: ELECTRIC POWER APPLICATIONS, INSTITUTION OF ELECTRICAL ENGINEERS, GB, vol. 146, no. 4, 8 juillet 1999 (1999-07-08), pages 383-390, XP006013381 ISSN: 1350-2352**
• **D'ANTONA G ET AL: "Definition and analysis of an electronic device for synchronous circular sampling of locally periodic signals" INSTRUMENTATION AND MEASUREMENT TECHNOLOGY CONFERENCE, 1994. IMTC/94. CONFERENCE PROCEEDINGS. 10TH ANNIVERSARY. ADVANCED TECHNOLOGIES IN I & M., 1994 IEEE HAMAMATSU, JAPAN 10-12 MAY 1994, NEW YORK, NY, USA,IEEE, 10 mai 1994 (1994-05-10), pages 733-736, XP010121971 ISBN: 0-7803-1880-3**

**Description**

DOMAINE TECHNIQUE DE L'INVENTION

L'invention concerne un procédé d'échantillonnage des signaux électriques d'une installation électrique multiphasée permettant de corriger les échantillons sur une phase prédéterminée, à partir des échantillons sur les phases correctes, les signaux électriques sur chaque phase de l'installation ayant une période fondamentale et l'échantillonnage étant réalisé avec une période d'échantillonnage fixe.

L'invention concerne également un dispositif d'échantillonnage des signaux électriques d'une installation électrique multiphasée permettant de corriger les échantillons sur une phase prédéterminée, à partir des échantillons sur les phases correctes, le dispositif comprenant des moyens de fourniture d'échantillons successivement sur chacune des phases et des moyens de traitement.

ETAT DE LA TECHNIQUE

Dans les installations électriques multiphasées, la mesure du courant, de la tension, ou de toute grandeur électrique qui en découle, telle que, par exemple, la puissance active, le facteur de puissance, la puissance réactive, requière généralement un échantillonnage sur chacune des phases de l'installation. Cet échantillonnage peut être réalisé avec une période d'échantillonnage fixe successivement sur chacune des phases de l'installation.

Les mesures sur de telles installations électriques multiphasées peuvent être entachées d'erreurs si, par exemple, le capteur de mesure sur l'une des phases est défaillant ou déconnecté. Il est également possible, pour une raison quelconque, telle que le manque de place ou le besoin de limiter le nombre de câbles, que l'une des phases de l'installation ne soit pas mesurée. Dans ces deux cas, on peut distinguer les phases correctes, c'est à dire les phases pour lesquelles les échantillons acquis ont des valeurs correctes, d'une phase prédéterminée pour laquelle les valeurs des échantillons peuvent être erronées, par exemple pour l'une des raisons évoquées ci-dessus. Dans de tels cas, il est nécessaire de reconstituer le signal électrique ou de corriger les valeurs des échantillons de la phase prédéterminée.

Les procédés d'échantillonnage de l'art antérieur autorisant une telle correction, ne permettent généralement pas de concilier une bonne précision avec une simplicité de mise en oeuvre. En général, les procédés d'échantillonnage connus requièrent une synchronisation de la période d'échantillonnage sur la période fondamentale des signaux électriques de l'installation et/ou la mise en oeuvre d'une mémoire de stockage des valeurs des échantillons dont la taille est significative.

PETROVIC P ET AL: "Digital method for power frequency measurement using synchronous sampling" IEE PROCEEDINGS: ELECTRIC POWER APPLICATIONS, INSTITUTION OF ELECTRICAL ENGINEERS, GB, vol. 146, no. 4, 8 juillet 1999 (1999-07-08), pages 383-390 décrit un procédé d'échantillonnage de signaux d'une installation électrique multiphasique dans lequel des échantillons sont fournis à des moments aléatoires au long de plusieurs périodes du signal (*equivalent time sampling technique*).

EXPOSE DE L'INVENTION

L'invention vise à remédier aux inconvénients des procédés d'échantillonnage de l'art antérieur.

L'invention concerne un procédé d'échantillonnage des signaux électriques d'une installation électrique multiphasée permettant de corriger les échantillons sur une phase prédéterminée, à partir des échantillons sur les phases correctes, les signaux électriques sur chaque phase de l'installation ayant une période fondamentale, l'échantillonnage étant réalisé avec une période d'échantillonnage fixe. Le procédé de l'invention comporte :

    (a) la fourniture d'échantillons successivement sur chacune des phases, chaque échantillon étant associé à un indice d'échantillonnage et à un instant d'échantillonnage,

    (b) la superposition d'au moins une partie des échantillons de chacune des phases correctes sur une même période fondamentale, en associant à chacun desdits échantillons un instant relatif défini par rapport au premier échantillon de ladite phase correcte,

    (c) la détermination d'une limite, pour chacune des phases correctes, ladite limite étant sensiblement égale à la valeur de l'indice d'échantillonnage d'un échantillon, pour lequel l'écart entre l'instant relatif associé audit échantillon et l'instant d'échantillonnage associé au premier échantillon de la phase prédéterminée est minimisé,

    (d) la sélection d'une série d'échantillons consécutifs sur chacune des phases correctes, le premier échantillon de la série ayant un indice d'échantillonnage égal à la limite, et

    (e) la correction d'une série des premiers échantillons consécutifs de la phase prédéterminée, ladite série étant corrigée à partir des valeurs des échantillons des séries sélectionnées lors de l'étape précédente.

De préférence, le procédé comporte la détermination d'une période reconstituée correspondant à l'écart entre les échantillons superposés sur une même période fondamentale d'une quelconque des phases correctes. De préférence, la période reconstituée est sensiblement égale à la différence entre :

- le produit de la période d'échantillonnage par le nombre d'échantillons fournis pendant une période fondamentale, et

- la période fondamentale.

Selon un mode de réalisation du procédé de l'invention, les étapes de superposition et de détermination d'une limite sont réalisées simultanément lors d'un processus itératif, pour chacune des phases correctes. De préférence, à chaque itération du processus itératif, un indice de superposition est incrémenté, ledit indice correspondant à un nombre de périodes reconstituées de l'instant relatif associé à chaque échantillon superposé. De préférence, le processus itératif, pour chaque phase correcte, comporte la détermination d'un écart de temps corrigé, associé à chaque échantillon superposé, entre l'instant relatif et l'instant d'échantillonnage associé au premier échantillon de la phase prédéterminée, la correction de l'écart de temps permettant d'exprimer celui-ci sur une même période fondamentale, la limite étant sensiblement égale à l'indice d'échantillonnage de l'échantillon, pour lequel l'écart de temps corrigé est minimisé. De préférence, la détermination d'un écart de temps corrigé associé à chaque échantillon superposé comporte:

- la détermination de l'instant relatif associé audit échantillon,

- la détermination d'un écart de temps associé audit échantillon, entre ledit instant relatif et l'instant d'échantillonnage associé au premier échantillon de la phase prédéterminée, et

- la correction de l'écart de temps pour le ramener sur une même période fondamentale.

Selon un mode de réalisation du procédé de l'invention, lors de l'étape de sélection et de l'étape de correction, les séries d'échantillons des phases correctes sélectionnées et la série des premiers échantillons de la phase prédéterminée comportent un nombre d'échantillons consécutifs égal à un nombre d'échantillons fournis pendant une période fondamentale.

L'invention concerne également, un dispositif d'échantillonnage des signaux électriques d'une installation électrique multiphasée permettant de corriger les échantillons sur une phase prédéterminée, à partir des échantillons sur les phases correctes, les signaux électriques sur chaque phase de l'installation ayant une période fondamentale, le dispositif comprenant des moyens de fourniture d'échantillons successivement sur chacune des phases, et des moyens de traitement. Dans le dispositif d'échantillonnage selon l'invention, les moyens de traitement permettent la correction des échantillons de la phase prédéterminée à partir des échantillons des phases correctes, à l'aide du procédé décrit précédemment.

BREVE DESCRIPTION DES FIGURES

D'autres avantages et caractéristiques ressortiront plus clairement de la description qui suit de modes particuliers de réalisation de l'invention, donnés à titre d'exemples non limitatifs, et représentés dans les figures annexées.

La figure 1 représente un organigramme représentant les étapes principales d'un mode de réalisation du procédé de l'invention.

La figure 2 représente, à titre d'exemple illustratif, un signal électrique sur l'une des phases correctes d'une installation ainsi que les échantillons fournis sur cette phase.

La figure 3 représente un exemple de superposition des échantillons de la figure 2 sur une période fondamentale.

La figure 4 représente, de manière plus détaillée, l'étape (b) de superposition et l'étape (c) de détermination des limites Lj pour chaque phase correcte d'un système triphasée.

La figure 5 représente un mode de réalisation du dispositif d'échantillonnage de l'invention.

La figure 6 représente un exemple de trame de sortie des moyens de conversion du dispositif d'échantillonnage de l'invention.

DESCRIPTION DETAILLEE DE MODES DE REALISATION PREFERES

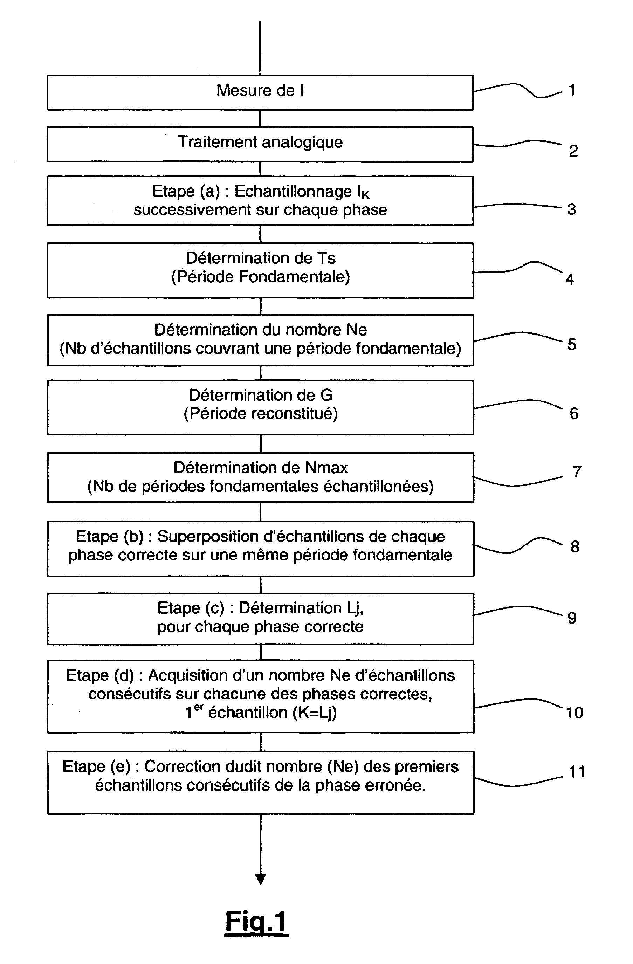

Le mode de réalisation du procédé de l'invention représenté à la figure 1 comporte différentes étapes permettant d'échantillonner les signaux électriques des phases correctes d'une installation multiphasée et permettant de corriger les valeurs des échantillons d'une phase prédéterminée de ladite installation.

La phase prédéterminée correspond généralement à une phase de l'installation pour laquelle les valeurs des échantillons sont erronées, quelle que soit la raison pour laquelle ces valeurs sont erronées, par exemple le capteur de mesure sur ladite phase est défaillant, déconnecté ou inexistant.

Une première étape d'acquisition 1 permet d'obtenir des signaux électriques, en l'occurrence un courant I, à partir d'un capteur de courant monté sur seulement les phases correctes de l'installation. Dans d'autres modes de réalisation non représentés, l'étape d'acquisition peut être une acquisition sur l'ensemble des phases de l'installation, les valeurs des échantillons de la phase prédéterminée faisant l'objet d'une correction par le procédé de l'invention.

Par phase correcte, on entend une phase pour laquelle les valeurs des échantillons sont initialement correctes ou représentatives du signal électrique mesuré sur ladite phase. Dans l'installation multiphasée sur laquelle est mis en oeuvre le procédé de l'invention, toutes les phases de l'installation sont dites phases correctes, à l'exception de la phase prédéterminée. Dans certains cas, les échantillons de la phase prédéterminée peuvent être corrects, le procédé permettant ainsi une confirmation ou une vérification des valeurs des échantillons de la phase prédéterminée.

Les signaux électriques I de chaque phase correcte sont ensuite envoyés dans une étape de traitement analogique 2, en l'occurrence un filtrage analogique de type passe-bas, lors de laquelle ces signaux électriques sont traités de façon à éliminer les composantes de haute fréquence. Le filtre passe-bas utilisé comporte généralement une fréquence de coupure suffisamment haute pour éliminer le bruit des signaux électriques.

Après le traitement analogique 2, les signaux électriques sont échantillonnés lors d'une étape (a) de fourniture d'échantillons de courant $I_K$ successivement sur chacune des phases. Cette étape (a) est représentée sur l'organigramme de la figure 1 par une boite fonctionnelle référencée 3. L'échantillonnage est réalisé avec une période d'échantillonnage Te fixe, sans aucune synchronisation avec la période fondamentale Ts des signaux électriques. La période d'échantillonnage Te est généralement très inférieure à la période fondamentale Ts, et souvent de manière à répondre au critère de Shannon, c'est à dire de sorte que le rapport entre la période fondamentale Ts et la période d'échantillonnage sur chaque phase soit au moins égal à deux. L'étape d'échantillonnage comporte généralement une conversion numérique.

Les échantillons $I_K$ sont fournis successivement sur chacune des phases, et ceci de manière cyclique. Chaque échantillon est ainsi associé à un indice d'échantillonnage K et à un instant d'échantillonnage égal à la valeur de l'indice K multipliée par la période d'échantillonnage Te.

Après l'échantillonnage, on dispose ainsi d'un nombre d'échantillons de courant $I_K$ suffisant pour permettre de reconstituer les échantillons de la phase prédéterminée ou de corriger les valeurs desdits échantillons. Ce nombre suffisant d'échantillons peut correspondre à la capacité de stockage d'un ensemble de traitement d'un dispositif d'échantillonnage dédié à la mise en oeuvre du procédé d'échantillonnage. Le nombre Nmax d'échantillons nécessaires pour corriger des valeurs des échantillons de la phase prédéterminée, avec une précision acceptable, est déterminé dans une étape ultérieure du procédé. Ce nombre Nmax d'échantillons nécessaires est évidemment inférieur ou égal au nombre d'échantillons pouvant être stockés dans les mémoires de l'ensemble de traitement du dispositif d'échantillonnage.

Dans d'autres modes de réalisation, l'étape 3 de fourniture d'échantillons peut être une simple acquisition d'échantillons déjà stockés dans des mémoires et constituer, dans ce cas, la première étape de ce procédé.

Les échantillons $I_K$ des signaux électriques sont ensuite envoyés vers une étape de détermination 4 de la période fondamentale Ts des signaux électriques. La période fondamentale Ts peut être déterminée par tout moyen connu de l'homme du métier. Cette étape de détermination de la période fondamentale Ts peut être facultative, en posant que la période fondamentale correspond à l'inverse d'une fréquence connue du réseau.

A titre d'exemple, pour déterminer la période fondamentale Ts, ou la fréquence fondamentale fs qui est égal à l'inverse de la période, on peut se fonder sur la détermination de la période des signaux électriques sur une plage de temps suffisamment large. On commence généralement par vérifier le signe de chaque échantillon d'un signal de tension ou de courant et, dès que le signe de ce signal change, on stocke dans une mémoire un premier instant $t_0$ correspondant au premier passage par zéro de ce signal. On répète ce processus pour un nombre de passages par zéro égal à 2K+1, correspondant à K périodes fondamentales Ts écoulées du signal, en ne retenant que l'instant du dernier passage par zéro, $t_{2K+1}$. De cette façon, il est possible de déterminer la fréquence fondamentale des signaux par la formule suivante : 
$$Ts = \frac{t_{2K+1} - t_0}{K}.$$

A partir de la période fondamentale déterminée à l'étape 4, le nombre Ne des échantillons fournis pendant une période fondamentale est déterminé lors d'une étape 5 du procédé de l'invention. En général, le nombre Ne d'échantillons fournis pendant une période fondamentale est égal à la somme de un et du nombre de périodes entières d'échantillonnage Te pendant une période fondamentale Ts. Le nombre Ne d'échantillons peut être déterminé par la formule suivante : 
$$Ne = INT(\frac{Ts}{Te}),$$ c'est à dire en déterminant la partie entière par défaut du rapport de la période fondamentale Ts sur la période d'échantillonnage Te. Il convient de noter que les échantillons fournis pendant une période fondamentale Ts ne correspondent pas aux échantillons consécutifs d'une même phase, mais aux échantillons fournis successivement sur chacune des phases de l'installation.

A partir de la période fondamentale déterminée à l'étape 4, une période reconstituée G est déterminée lors d'une étape 6. Cette période reconstituée G correspond à l'écart entre les échantillons $I_K$ superposés sur une même période fondamentale. La superposition des échantillons sur une même période fondamentale est une étape ultérieure du procédé de l'invention, lors de laquelle on positionne chaque échantillon d'une phase correcte sur une même période fondamentale. Cette étape de superposition est décrite, ci-après, de manière plus détaillée. L'étape 6 permet, quant à elle, de déterminer préalablement la période reconstituée G, cette dernière étant utilisée par le procédé de l'invention, lors de l'étape de superposition ultérieure. La période reconstituée G déterminée à l'étape 6 est sensiblement égale à la différence entre le produit de la période d'échantillonnage Te par le nombre Ne d'échantillons fournis pendant une période fondamentale Ts et la période fondamentale Ts. Ainsi, la période reconstituée peut être déterminée par la formule suivante : $G = Ne * Te - Ts$

A partir de la période fondamentale déterminée à l'étape 4, le nombre Nmax d'échantillons nécessaires pour corriger des valeurs des échantillons de la phase prédéterminée avec une précision acceptable est déterminé lors d'une étape 7. Ce nombre Nmax d'échantillons nécessaires est sensiblement égal à un nombre entier de périodes fondamentales pendant lesquelles est réalisé l'échantillonnage. Ce nombre est déterminé en fonction de la durée totale Tmax de l'échantillonnage, par exemple à l'aide de la formule suivante :

$$N\max = INT(\frac{T\max}{Ts}) - 1$$

Au moins une partie des échantillons de chaque phase correcte, fournis lors de l'étape 3, sont ensuite superposés sur une même période fondamentale de ladite phase. Cette étape de superposition constitue l'étape (b) du procédé de l'invention, représentée sur l'organigramme de la figure 1 par une boite fonctionnelle référencée 8.

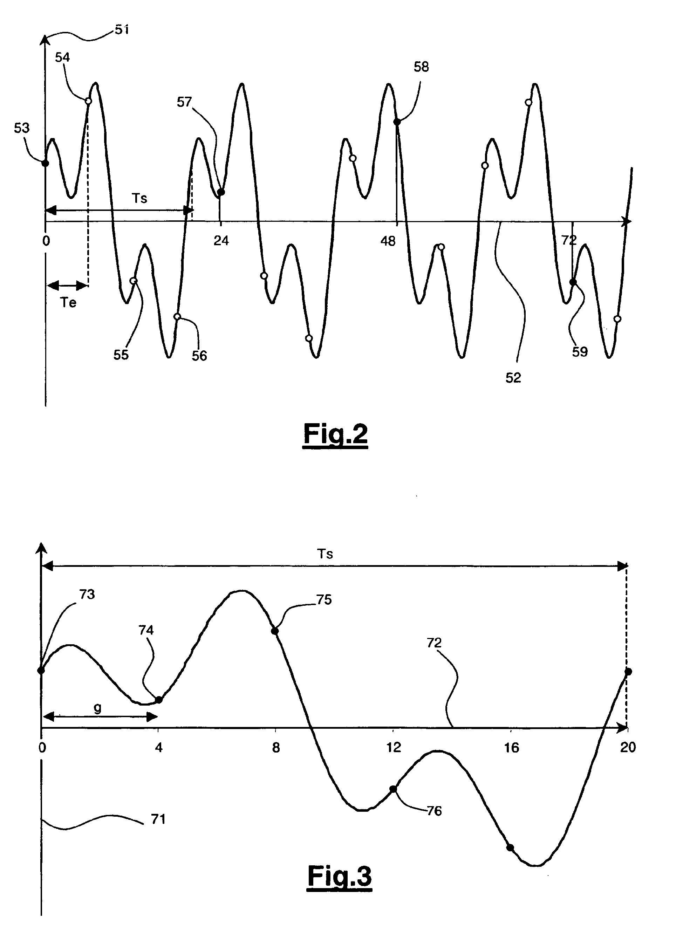

L'étape de superposition est illustrée par les graphiques représentés sur les figures 2 et 3. Le signal électrique 51 représenté à la figure 2 a été obtenu sur une phase correcte, ci-après dénommée P1, d'une installation comportant quatre phases, c'est à dire P1, P2, P3 et le neutre. Le signal électrique sur chacune des phases du système présente une période fondamentale Ts de 20 ms. Le signal 51 est représenté en fonction du temps 52 sur une durée égale à environ quatre fois la période fondamentale. La période d'échantillonnage Te utilisée est de 6 secondes. Les points consécutifs de la figure 2 correspondent à la réalisation d'un échantillonnage, et sont donc séparés par une durée égale à la période d'échantillonnage, mais seuls les points ayant un fond sombre sont représentatifs des échantillons du signal électrique de la phase P1 représenté à la figure 2. L'installation comportant quatre phases, les échantillons du signal de la phase P1 sont séparés par une durée égale à quatre fois la période d'échantillonnage Te, c'est à dire 24 ms. Notons que cet exemple est uniquement donné à titre illustratif, et que la période d'échantillonnage Te choisie ne permet pas de vérifier le critère de Shannon. Ainsi, les échantillons consécutifs de la phase P1, représentés par des cercles sombres ayant pour références 53, 57, 58 et 59, sont respectivement prélevés à des instants de 0, 24, 48 et 72 ms. Les échantillonnages sur les autres phases sont représentés par des cercles blancs. Par exemple, les échantillonnages représentés par les cercles blancs ayant pour références 54, 55 et 56 représentent les instants d'échantillonnage réalisés successivement sur les phases P2, P3 et le neutre.

La superposition des échantillons d'une phase sur une même période fondamentale revient à déterminer, pour chacun de ces échantillons, un instant relatif qui correspond à la position temporelle de l'échantillon par rapport à une référence temporelle de ladite période fondamentale. Généralement, cette référence temporelle est définie par rapport à l'instant d'échantillonnage du premier échantillon de la phase considérée.

Dans le cas illustré aux figures 2 et 3, la référence temporelle est donc la position temporelle du premier échantillon 53 du signal électrique de la phase P1. Le premier échantillon 53 du signal de la phase P1 est donc, après superposition, représenté sur les axes 71 et 72 de la figure 3 par l'échantillon 73. Cet échantillon constitue ainsi le premier échantillon de l'ensemble des échantillons superposés, de la phase P1, sur une période d'échantillonnage. Le deuxième échantillon 57 du signal de la phase P1 est associé, quant à lui, à un instant d'échantillonnage de 24 ms, c'est à dire 4 ms après la référence temporelle de la deuxième période fondamentale du signal de la phase P1. Ce deuxième échantillon 57 est donc également associé à un instant relatif de 4 ms et, après superposition, il est représenté à la figure 3 par l'échantillon 74. De la même façon, le troisième échantillon 58 du signal de la phase P1 est associé à un instant d'échantillonnage de 48 ms, c'est à dire 8 ms après la référence temporelle de la troisième période fondamentale du signal de la phase P1. Ce troisième échantillon 58 est donc également associé à un instant relatif de 8 ms et, après superposition, il est représenté à la figure 3 par l'échantillon 75. Par une méthode similaire, le quatrième échantillon 59 est associé à un instant relatif de 12 ms et, après superposition, il est représenté à la figure 3 par l'échantillon 76.

Les échantillons de la phase P1 sont donc séparés par une durée de 4 ms qui correspond à la période reconstituée déterminée à l'étape 6 du procédé de la figure 1. Ainsi, lors de l'étape (b) de superposition du procédé de l'invention ou lors de l'étape 8 du mode de réalisation de la figure 1, chaque échantillon d'une phase donnée est associé à un instant d'échantillonnage et à un instant relatif qui est sensiblement égal à la valeur d'un indice de superposition M multipliée par la période reconstituée G. Les échantillons consécutifs 53, 57, 58 et 59 de la phase P1, tels que représentés à la figure 2, sont donc associés à un indice d'échantillonnage K respectivement égal à 1, 5, 9 et 13 et à un indice de superposition M respectivement égal à 0, 1, 2 et 3. Cette étape de superposition peut être réalisée, pour chaque phase correcte de l'installation, par un processus itératif, lors duquel l'indice de superposition M, correspondant au nombre de périodes reconstituées, est incrémenté.

L'étape 8 de superposition est suivie par une étape 9 de détermination d'une limite Lj, pour chacune des phases correctes de l'installation, ladite limite étant égale à la valeur de l'indice d'échantillonnage K d'un échantillon $I_{Lj}$, pour lequel l'écart entre l'instant relatif associé audit échantillon et l'instant d'échantillonnage associé au premier échantillon de la phase prédéterminée est minimisé. Cette étape 9 du mode de réalisation représenté à la figure 1 correspond à l'étape (c) du procédé de l'invention. Cette étape 9 de détermination d'une limite Lj, pour chacune des phases correctes de l'installation, peut être réalisée par un processus itératif, lors duquel l'indice de superposition M est incrémenté.

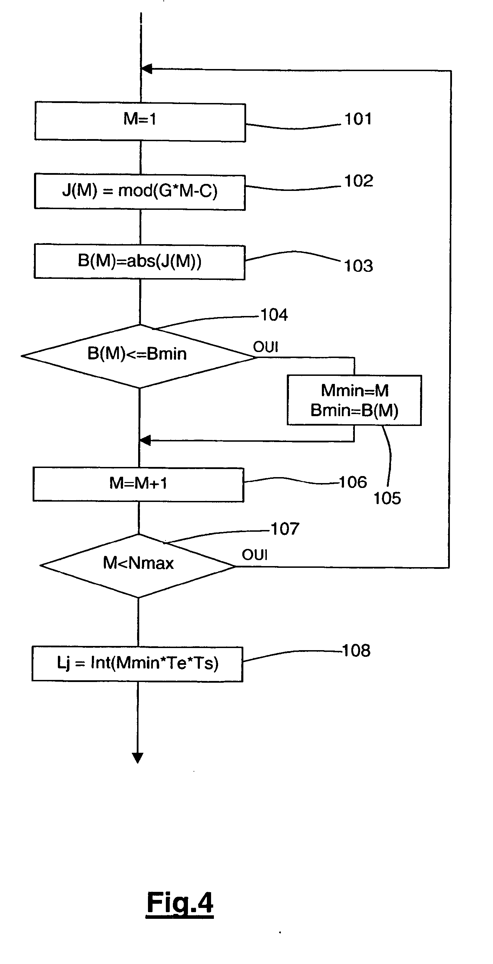

Selon un mode de réalisation préféré, l'étape 8 de superposition et l'étape 9 de détermination d'une limite Lj, sont réalisées pour chacune des phases correctes de l'installation, par un même processus itératif, lors duquel l'indice de superposition M est incrémenté. Ce processus itératif des étapes 8 et 9, correspondant à l'étape (b) de superposition et à l'étape (c) de détermination l'une limite Lj, est réalisé selon l'organigramme représenté à la figure 4. A chaque itération du processus itératif, l'indice de superposition M est incrémenté, ledit indice de superposition correspondant à un nombre de périodes reconstituées G de l'instant relatif associé à chaque échantillon superposé.

Le processus itératif, pour une phase correcte donnée, et pour chaque échantillon de ladite phase correcte, comporte :

- une étape d'initialisation 101 permettant d'initialiser la première itération au second échantillon superposé, en posant que l'indice de superposition M est égal à 1,

- des étapes de détermination 102 et 103 de la valeur absolue B(M) d'un écart de temps corrigé J(M), associé à chaque échantillon superposé, entre l'instant relatif et l'instant d'échantillonnage associé au premier échantillon de la phase prédéterminée, la correction permettant d'exprimer l'écart de temps sur une même période fondamentale,

- une étape 104 de test pour déterminer si la valeur absolue de l'écart de temps corrigé B(M), déterminé aux étapes 102 et 103, est inférieure à une valeur seuil stockée dans un premier registre Bmin,

- une étape 105, mise en oeuvre quand le test de l'étape 104 est positif, et lors de laquelle la valeur de l'indice de superposition M est stockée dans un second registre Mmin et la valeur du premier registre Bmin est remplacée par l'écart B(M),

- une étape 106 d'incrémentation de l'indice de superposition M,

- une étape de test 107, pour arrêter le processus itératif quand l'indice de superposition M est supérieur au nombre Nmax d'échantillons nécessaires pour corriger des valeurs des échantillons de la phase prédéterminée, et

- une étape de détermination 108 de la limite Lj comme étant sensiblement égale à la partie entière par défaut du produit de la valeur du second registre Mmin multipliée par la période fondamentale Ts et par la période d'échantillonnage Te.

De manière plus détaillée, l'étape 102 de détermination d'un écart de temps corrigé J(M) commence, pour un échantillon de la phase correcte considérée, par la détermination de l'instant relatif associé audit échantillon, défini par rapport au premier échantillon de ladite phase correcte, en multipliant la période reconstituée G par l'indice de superposition M.

Ensuite, pour ce même échantillon de la phase correcte considérée, on détermine un écart de temps associé audit échantillon, entre l'instant relatif, c'est à dire le produit G*M de la période reconstituée G par l'indice de superposition M, et l'instant d'échantillonnage associé au premier échantillon de la phase prédéterminée. Dans le cas d'une installation à quatre phases P1, P2, P3 et N, et en considérant que la phase P2 est la phase prédéterminée, l'écart de temps associé à un échantillon des phases correctes P1, P3 et N est sensiblement égal à la différence entre le produit G*M et une constante Cj variant en fonction de la phase j considérée. Pour la phase P1, la constante $C_{P1}$ est égale à une fois la période d'échantillonnage Te, cette dernière étant comptée positivement du fait que le premier échantillon de la phase P2 prédéterminée est en en retard d'une fois la période reconstituée par rapport au premier échantillon de la phase P1. Pour la phase P3, la constante $C_{P3}$ est égale à une fois la période d'échantillonnage Te, cette dernière étant comptée négativement du fait que le premier échantillon de la phase P2 prédéterminée est en en avance d'une fois la période reconstituée par rapport au premier échantillon de la phase P3. Pour la phase N, la constante $C_N$ est égale à deux fois la période d'échantillonnage Te, cette dernière étant comptée négativement du fait que le premier échantillon de la phase P2 prédéterminée est en en avance de deux fois la période reconstituée par rapport au premier échantillon de la phase N. Ainsi, dans le cas d'une installation à quatre phases P1, P2, P3 et N, et en considérant que la phase P2 est erronée, les écarts de temps associés à un échantillon des phases correctes P1, P3. et N sont respectivement égaux à G*M-Te, G*M+Te et G*M+2Te.

Ensuite, pour ce même échantillon de la phase correcte considérée, on réalise une correction de l'écart de temps pour exprimer cet écart sur une même période fondamentale. Ainsi, quand l'écart de temps associé à un échantillon est supérieur à la période fondamentale, on corrige ledit écart en déterminant un reliquat qui correspond au reste de la division dudit écart par la période fondamentale Ts pour obtenir un nombre entier. Ce reliquat peut également s'exprimer par une fonction mathématique, connue sous le nom de modulo, par une formule du type Mod(a,b)=a-b*INT(a/b), la fonction INT (a/b) correspondant à la partie entière par défaut de a/b. Ainsi, dans le cas d'une installation à quatre phases P1, P2, P3 et N, et en considérant que la phase P2 est erronée, les écarts de temps corrigés J(M) associé à un échantillon des phases correctes P1, P3 et N sont respectivement égaux à Mod(G*M-Te,Ts), Mod (G*M+Te, Ts) et Mod (G*M+2Te,Ts).

Les étapes 8 et 9 de superposition et de détermination d'une limite Lj, détaillées précédemment par la description de la figure 4, sont suivies par une étape 10 de sélection d'une série d'échantillons consécutifs sur chacune des phases correctes, le premier échantillon de la série ayant un indice d'échantillonnage K égal à ladite limite Lj, le nombre d'échantillons de ladite série étant égal au nombre Ne d'échantillons fournis pendant une période fondamentale déterminé à l'étape 5. Cette étape 10 du mode de réalisation représenté à la figure 1 correspond à l'étape (d) du procédé de l'invention.

L'étape 10 de sélection d'une série d'échantillons consécutifs sur chacune des phases correctes est suivie par une étape 11 de correction d'une série des premiers échantillons consécutifs de la phase prédéterminée, le nombre d'échantillons de ladite série étant égal au nombre Ne d'échantillons fournis pendant une période fondamentale. La série des premiers échantillons de la phase prédéterminée est corrigée à partir des valeurs des échantillons des séries sélectionnées lors de l'étape 9 précédente. Cette étape 11 du mode de réalisation représenté à la figure 1 correspond à l'étape (e) du procédé de l'invention.

Lors de cette étape (11) ou (e) de correction, chaque échantillon de la série des premiers échantillons de la phase prédéterminée peut être corrigé à partir des échantillons ayant le même rang des séries d'échantillons consécutifs de chacune des phases correctes. En effet, le procédé de l'invention permet de déterminer des séries de Ne échantillons consécutifs, sur chacune des phases de l'installation, pour lesquels les échantillons de même rang de chacune desdites séries peuvent être considérés comme ayant été fournis sensiblement en même temps, ou plus exactement, avec un décalage temporel minimisé. En prenant en considération les lois de l'électricité régissant les signaux électriques de chacune des phases, il est donc possible, à partir de l'ensemble des échantillons ayant un même rang sur chacune des séries, de corriger l'échantillon de la phase prédéterminée en fonction des autres échantillons des phases correctes.

Dans le mode de réalisation de la figure 1, les signaux électriques échantillonnés sont des courants. Dans ce cas, il est connu que la somme des courants de chaque phase est égale à zéro. Ainsi, la somme des échantillons de courant de chacune des séries ayant un même rang est égale à zéro. Il est donc possible de corriger l'échantillon de la phase prédéterminée en fonction des échantillons des phases correctes. En réalisant cette correction sur chaque échantillon de la série d'échantillons de la phase prédéterminée, il est donc possible de reconstituer le signal électrique, en l'occurrence le courant, de ladite phase prédéterminée.

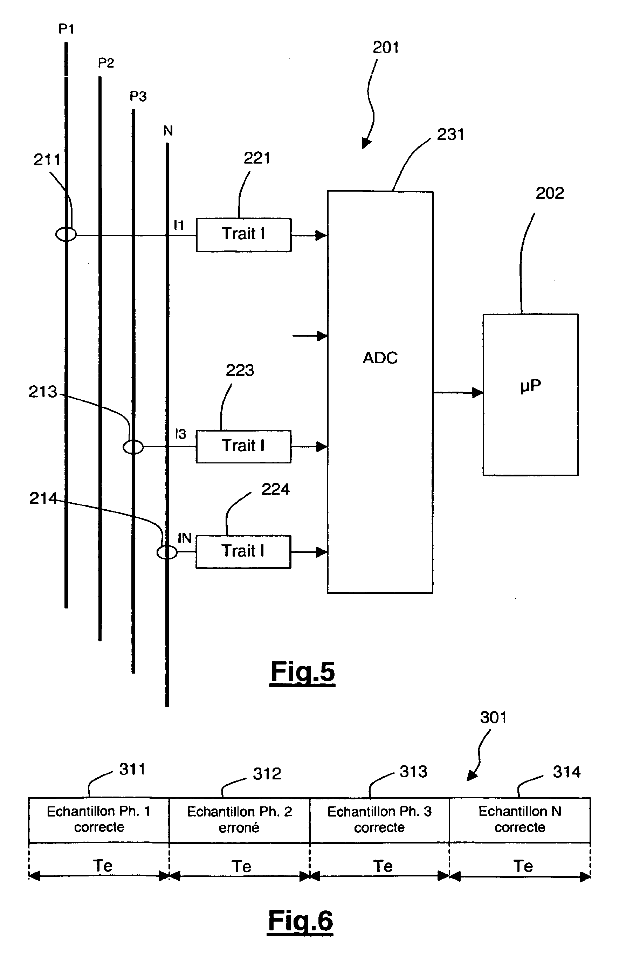

Le dispositif d'échantillonnage de l'invention est représenté à la figure 5. L'installation multiphasée sur laquelle le dispositif de l'invention est mis en oeuvre est une installation tétraphasée, c'est à dire comportant quatre phases, en l'occurrence, trois phases P1, P2 et P3 et le neutre N. Le dispositif d'échantillonnage représenté à la figure 5 comporte des moyens de fourniture d'échantillons 201 successivement sur chacune des phases, et des moyens de traitement 202. Les moyens de fourniture d'échantillons 201 comportent, quant à eux, des capteurs de courant 211, 213 et 214 montés sur respectivement les phases P1, P3 et N dites phases correctes. La phase P2, quant à elle, ne comporte aucun capteur de courant et est donc qualifiée de phase prédéterminée, du fait que les échantillons de courant de la phase 2 ne correspondent pas effectivement à des grandeurs représentatives du courant. Les capteurs 211, 213 et 214 sont respectivement connectés à des moyens de traitement analogique 221, 223 et 224. Ces moyens de traitement peuvent être des filtres analogiques pour atténuer un bruit haute fréquence et pour empêcher le repliement du spectre des harmoniques des signaux de courant. Les moyens de fourniture d'échantillons 201 comportent également un convertisseur numérique 231 comportant quatre entrées de mesures reliées aux quatre phases de l'installation tétraphasée et permettant l'échantillonnage et la conversion numérique des signaux électriques de courant avec une fréquence d'échantillonnage fixe. Dans le cas de la figure 5, la deuxième entrée du convertisseur correspondant à la phase P2 prédéterminée n'est pas reliée, et les échantillons prélevés sur cette entrée sont donc erronés. Le convertisseur 231 comporte une sortie permettant de fournir les échantillons de chacune des phases sous la forme d'une trame, par des moyens de multiplexage appropriés.

Comme cela est représenté à la figure 6, la trame de sortie 301 des moyens de conversion numérique comportent quatre échantillons 311, 312, 313 et 314 correspondant au courant sur chacune des phases P1, P2, P3 et N de l'installation triphasée. Dans le cas représenté à la figure 6, chaque échantillon de la trame 301 s'étend sur une durée égale à la période fondamentale Te.

Les moyens de traitement 202 permettent la correction des échantillons de la phase prédéterminée à partir des échantillons des phases correctes, à l'aide du procédé d'échantillonnage décrit précédemment. Ces moyens de traitement comportent un module de mémoires, non représenté, permettant de stocker les échantillons de courant de chacune des phases.

Un avantage de l'invention est notamment de minimiser la taille de ce module de mémoires des moyens de traitement.

Un autre avantage de l'invention est l'absence de synchronisation de la fréquence d'échantillonnage, ce qui permet notamment de simplifier les moyens de traitement.

## Revendications

**1.** Procédé d'échantillonnage des signaux électriques d'une installation électrique multiphasée permettant de corriger les échantillons sur une phase prédéterminée, à partir des échantillons sur les phases correctes, les signaux électriques sur chaque phase (j) de l'installation ayant une période fondamentale (Ts), l'échantillonnage étant réalisé avec une période d'échantillonnage (Te) fixe, procédé **caractérisé en ce qu'**il comprend:

(a) la fourniture d'échantillons ($I_K$) successivement sur chacune des phases, chaque échantillon étant associé à un indice d'échantillonnage (K) et à un instant d'échantillonnage,
(b) la superposition d'au moins une partie des échantillons de chacune des phases correctes sur une même période fondamentale, en associant à chacun desdits échantillons un instant relatif défini par rapport au premier échantillon de ladite phase correcte,
(c) la détermination d'une limite (Lj), pour chacune des phases correctes, ladite limite étant sensiblement égale à la valeur de l'indice d'échantillonnage (K) d'un échantillon ($I_{Lj}$), pour lequel l'écart entre l'instant relatif associé audit échantillon ($I_{Lj}$) et l'instant d'échantillonnage associé au premier échantillon de la phase prédéterminée est minimisé,
(d) la sélection d'une série d'échantillons consécutifs sur chacune des phases correctes, le premier échantillon de la série ayant un indice d'échantillonnage (K) égal à la limite (Lj), et
(e) la correction d'une série des premiers échantillons consécutifs de la phase prédéterminée, ladite série étant corrigée à partir des valeurs des échantillons des séries sélectionnées lors de l'étape précédente.

**2.** Procédé selon la revendication 1, **caractérisé en ce qu'**il comporte la détermination d'une période reconstituée (G) correspondant à l'écart entre les échantillons ($I_K$) superposés sur une même période fondamentale d'une quelconque des phases correctes.

**3.** Procédé selon la revendication 2, **caractérisé en ce que** la période reconstituée (G) est sensiblement égale à la différence entre :

- le produit de la période d'échantillonnage (Te) par le nombre (Ne) d'échantillons fournis pendant une période fondamentale (Ts), et

- la période fondamentale (Ts).

**4.** Procédé selon l'une des revendications 1 à 3, **caractérisé en ce que** les étapes de superposition (b) et de détermination (c) d'une limite (Lj) sont réalisées simultanément lors d'un processus itératif, pour chacune des phases correctes(j).

**5.** Procédé selon la revendication 4, **caractérisé en ce qu'**à chaque itération du processus itératif, un indice de superposition (M) est incrémenté, ledit indice correspondant à un nombre de périodes reconstituées (G) de l'instant relatif associé à chaque échantillon superposé.

**6.** Procédé selon la revendication 5, **caractérisé en ce que** le processus itératif, pour chaque phase correcte, comporte la détermination (102) d'un écart de temps corrigé, associé à chaque échantillon superposé, entre l'instant relatif et l'instant d'échantillonnage associé au premier échantillon de la phase prédéterminée, la correction de l'écart de temps permettant d'exprimer celui-ci sur une même période fondamentale, la limite (Lj) étant sensiblement égale à l'indice d'échantillonnage (K) de l'échantillon ($I_{Lj}$), pour lequel l'écart de temps corrigé est minimisé.

**7.** Procédé selon la revendication 6, **caractérisé en ce que** la détermination d'un écart de temps corrigé (102) associé à chaque échantillon superposé comporte :

- la détermination de l'instant relatif associé audit échantillon (M*G),
- la détermination d'un écart de temps associé audit échantillon, entre ledit instant relatif et l'instant d'échantillonnage associé au premier échantillon de la phase prédéterminée (M*G-Cj), et
- la correction de l'écart de temps pour le ramener sur une même période fondamentale (Mod ( M*G-Cj)).

**8.** Procédé selon l'une des revendications 1 à 7, **caractérisé en ce que**, lors de l'étape (d) de sélection et de l'étape (e) de correction, les séries d'échantillons des phases correctes sélectionnés et la série des premiers échantillons de la phase prédéterminée comportent un nombre d'échantillons consécutifs égal à un nombre (Ne) d'échantillons fournis pendant une période fondamentale (Ts).

**9.** Dispositif d'échantillonnage des signaux électriques d'une installation électrique multiphasée permettant de corriger les échantillons sur une phase prédéterminée, à partir des échantillons sur les phases correctes, les signaux électriques sur chaque phase (j) de l'installation ayant une période fondamentale (Ts), le dispositif comprenant :

> - des moyens de fourniture d'échantillons ($I_K$) successivement sur chacune des phases, et
> - des moyens de traitement,

**caractérisé en ce que** les moyens de traitement permettent la correction des échantillons de la phase prédéterminée à partir des échantillons des phases correctes, à l'aide du procédé selon l'une des revendications 1 à 8.

**Claims**

1. A method for sampling the electrical signals of a multiphase electrical installation enabling the samples on a predetermined phase to be corrected from the samples on the correct phases, the electrical signals on each phase (j) of the installation having a fundamental period (Ts), sampling being performed with a fixed sampling period (Te), a method **characterized in that** it comprises:

   > (a) supply of samples ($I_K$) successively on each of the phases, each sample being associated with a sampling index (K) and with a sampling time,
   > (b) superposition of at least a part of the samples of each of the correct phases over the same fundamental period, associating with each of said samples a relative time defined with respect to the first sample of said correct phase,
   > (c) determination of a limit (Lj) for each of the correct phases, said limit being substantially equal to the value of the sampling index (K) of a sample ($I_{Lj}$), for which the difference between the relative time associated with said sample ($I_{Lj}$) and the sampling time associated with the first sample of the predetermined phase is minimized,
   > (d) selection of a series of consecutive samples on each of the correct phases, the first sample of the series having a sampling index (K) equal to the limit (Lj), and
   > (e) correction of a series of the first consecutive samples of the predetermined phase, said series being corrected from the values of the samples of the series selected in the previous step.

2. The method according to claim 1, **characterized in that** it comprises determination of a reconstituted period (G) corresponding to the difference between the superposed samples ($I_K$) over the same fundamental period of any one of the correct phases.

3. The method according to claim 2, **characterized in that** the reconstituted period (G) is substantially equal to the difference between:

   > - the product of the sampling period (Te) by the number (Ne) of samples supplied during a fundamental period (Ts), and
   > - the fundamental period (Ts).

4. The method according to one of claims 1 to 3, **characterized in that** the steps of superposition (b) and determination (c) of a limit (Lj) are performed simultaneously in an iterative process, for each of the correct phases (j).

5. The method according to claim 4, **characterized in that** a superposition index (M) is incremented at each iteration of the iterative process, said index corresponding to a number of reconstituted periods (G) of the relative time associated with each superposed sample.

6. The method according to claim 5, **characterized in that** the iterative process, for each correct phase, comprises determination (102) of a corrected time difference associated with each superposed sample between the relative time and the sampling time associated with the first sample of the predetermined phase, correction of the time difference enabling the latter to be expressed over one and the same fundamental period, the limit (Lj) being substantially equal to the sampling index (K) of the sample ($I_{Lj}$), for which the corrected time difference is minimized.

7. The method according to claim 6, **characterized in that** determination of a corrected time difference (102) associated with each superposed sample comprises:

   > - determination of the relative time associated with said sample (M*G),
   > - determination of a time difference associated with said sample between said relative time and the sampling time associated with the first sample of the predetermined phase (M*G-Cj), and
   > - correction of the time difference to adjust it to the same fundamental period (Mod(M*G-Cj)).

8. The method according to one of claims 1 to 7, **characterized in that**, in the selection step (d) and the correction step (e), the series of samples of the selected correct phases and the series of the first samples of the predetermined phase comprise a number of consecutive samples equal to a number (Ne) of samples supplied during a fundamental period (Ts).

9. A device for sampling the electrical signals of a multiphase electrical installation enabling the samples on a predetermined phase to be corrected from the samples on the correct phases, the electrical signals on each phase (j) of the installation having a fundamental period (Ts), the device comprising:

- means for successively supplying samples (IK) on each of the phases, and
- processing means,

**characterized in that** the processing means enable the samples of the predetermined phase to be corrected from the samples of the correct phases by means of the method according to one of claims 1 to 8.

**Patentansprüche**

1. Verfahren zur Abtastung elektrischer Signale eines elektrischen Mehrphasensystems, das die Korrektur der Abtastwerte einer bestimmten Phase mithilfe der Abtastwerte der korrekten Phasen erlaubt, wobei die elektrischen Signale jeder Phase (j) des Systems eine Grund-Periodendauer (Ts) aufweisen und die Abtastung mit einer festen Abtast-Periodendauer (Te) durchgeführt wird, **dadurch gekennzeichnet, dass** das Verfahren folgende Schritte umfasst:

(a) Bereitstellung von nacheinander an jeder einzelnen Phase aufgenommenen Abtastwerten ($I_K$), wobei jeder Abtastwert einem Abtastindex (K) und einem Abtastzeitpunkt zugeordnet wird,

(b) Überlagerung mindestens eines Teils der über die gleiche Grund-Periodendauer aufgenommenen Abtastwerte jeder korrekten Phase, wobei jedem der genannten Abtastwerte ein relativer Zeitpunkt in Bezug zum ersten Abtastwert der genannten korrekten Phase zugeordnet wird,

(c) Bestimmung eines Grenzwerts (Lj) für jede korrekte Phase, welcher Grenzwert annähernd identisch mit dem Abtastindex (K) eines Abtastwerts ($I_{Lj}$) ist, bei dem die Zeitdifferenz zwischen dem, dem genannten Abtastwert ($I_{Lj}$) zugeordneten relativen Zeitpunkt und dem, dem ersten Abtastwert der bestimmten Phase zugeordneten Abtastzeitpunkt minimal ist,

(d) Auswahl einer Reihe von aufeinander folgenden Abtastwerten jeder korrekten Phase, wobei der erste Abtastwert der Reihe einen Abtastindex (K) aufweist, der dem Grenzwert (Lj) entspricht, und

(e) Korrektur einer Reihe der ersten aufeinander folgenden Abtastwerte der bestimmten Phase in Abhängigkeit von den Abtastwerten der im vorausgehenden Schritt ausgewählten Reihen.

2. Verfahren nach Anspruch 1, **dadurch gekenn-**

**zeichnet, dass** es die Bestimmung einer rekonstruierten Periodendauer (G) entsprechend der Zeitdifferenz zwischen den überlagerten Abtastwerten ($I_K$) innerhalb der gleichen Grund-Periodendauer irgendeiner korrekten Phase umfasst.

3. Verfahren nach Anspruch 2, **dadurch gekennzeichnet dass** die rekonstruierte Periodendauer (G) annähernd der Differenz zwischen:

- dem Produkt aus der Abtast-Periodendauer (Te) und der Anzahl (Ne) der innerhalb einer Grund-Periodendauer (Ts) bereitgestellten Abtastwerte und
- der Grund-Periodendauer (Ts) entspricht.

4. Verfahren nach einem der Ansprüche 1 bis 3, **dadurch gekennzeichnet, dass** der Überlagerungsschritt (b) und der Schritt (c) zur Bestimmung eines Grenzwerts (Lj) für jede korrekte Phase (j) in einem iterativen Prozess gleichzeitig durchgeführt werden.

5. Verfahren nach Anspruch 4, **dadurch gekennzeichnet, dass** bei jedem Durchlauf des iterativen Prozesses ein Überlagerungsindex (M) erhöht wird, welcher Index einer Anzahl von rekonstruierten Periodendauern (G) für den, jedem überlagerten Abtastwert zugeordneten relativen Zeitpunkt entspricht.

6. Verfahren nach Anspruch 5, **dadurch gekennzeichnet, dass** der iterative Prozess für jede korrekte Phase die Bestimmung (102) einer, jedem überlagerten Abtastwert zugeordneten korrigierten Zeitdifferenz zwischen dem relativen Zeitpunkt und dem, dem ersten Abtastwert der bestimmten Phase zugeordneten Abtastwert umfasst, wobei die Korrektur der Zeitdifferenz deren Angabe für die gleiche Grund-Periodendauer erlaubt und der Grenzwert (Lj) annähernd identisch ist mit dem Abtastindex (K) des Abtastwerts ($I_{Lj}$), bei dem die korrigierte Zeitdifferenz minimal ist.

7. Verfahren nach Anspruch 6, **dadurch gekennzeichnet, dass** die Bestimmung einer, jedem überlagerten Abtastwert zugeordneten korrigierten Zeitdifferenz (102) folgende Schritte umfasst:

- Bestimmung des dem genannten Abtastwert zugeordneten relativen Zeitpunkts (M*G),
- Bestimmung einer dem genannten Abtastwert zugeordneten Zeitdifferenz zwischen dem genannten relativen Zeitpunkt und dem, dem ersten Abtastwert der bestimmten Phase zugeordneten Abtastzeitpunkt (M*G-Cj) sowie
- Korrektur der Zeitdifferenz für deren Bezug auf eine gleiche Grund-Periodendauer (Mod( M*G-Cj)).

8. Verfahren nach einem der Ansprüche 1 bis 7, **dadurch gekennzeichnet, dass** während des Auswahlschrittes (d) und des Korrekturschrittes (e) die ausgewählten Abtastwertreihen der korrekten Phasen und die Reihe der ersten Abtastwerte der bestimmten Phase eine Anzahl von aufeinander folgenden Abtastwerten umfassen, die einer Anzahl (Ne) von, über eine Grund-Periodendauer (Ts) bereitgestellten Abtastwerten entspricht.

9. Einrichtung zur Abtastung elektrischer Signale eines elektrischen Mehrphasensystems, welche die Korrektur der Abtastwerte einer bestimmten Phase mithilfe der Abtastwerte der korrekten Phasen erlaubt, wobei die elektrischen Signale jeder Phase (j) des Systems eine Grund-Periodendauer (Ts) aufweisen und die Einrichtung

    - Mittel zur Bereitstellung von nacheinander in jeder Phase aufgenommenen Abtastwerten ($I_K$) sowie
    - Verarbeitungsmittel umfasst,

    **dadurch gekennzeichnet, dass** die Verarbeitungsmittel mithilfe des Verfahrens nach einem der Ansprüche 1 bis 8 die Korrektur der Abtastwerte der bestimmten Phase mithilfe der Abtastwerte der korrekten Phasen erlauben.

**Fig.1**

**Fig.2**

**Fig.3**

**Fig.4**

P1

P2

P3

N

211

221

I1 | Trait I |

201

231

ADC

202

μP

213

223

I3 | Trait I |

214

224

IN | Trait I |

**Fig.5**

301

| 311 | 312 | 313 | 314 |
|---|---|---|---|
| Echantillon Ph. 1 correcte | Echantillon Ph. 2 erroné | Echantillon Ph. 3 correcte | Echantillon N correcte |
| Te | Te | Te | Te |

**Fig.6**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **PETROVIC P et al.** Digital method for power frequency measurement using synchronous sampling. *IEE PROCEEDINGS: ELECTRIC POWER APPLICATIONS, INSTITUTION OF ELECTRICAL ENGINEERS, GB,* 08 Juillet 1999, vol. 146 (4), 383-390